# EUROPEAN PATENT APPLICATION

(11) **EP 4 707 840 A2**
(43) Date of publication of application: **11.03.2026**
(21) Application number: 25200020.3
(22) Date of filing: 03.09.2025
(51) Int. Cl.: G01R 33/12, B62D 15/02, G01D 5/14, G01R 33/00

(54) **A MAGNETIC SENSOR SYSTEM AND INITIALIZATION METHOD**

(30) Priority: 04.09.2024 US 202463690464 P
(71) Applicant: Analog Devices International Unlimited Company, Co. Limerick (IE)
(72) Inventor: Schmitt, Jochen, Limerick (IE); Kubik, Jan, Limerick (IE); Cosgrave, Gavin Patrick, Limerick (IE)
(74) Representative: Halliwell, Bethan Frances

(57) **Abstract**

The present disclosure provides magnetic sensor system that includes a magnetic sensing device comprising a magnetic multi-turn sensor, and a method of initializing the magnetic multi-turn sensor into a known state with a defined domain wall configuration ready for use. A strong magnetic field is first applied to fill the MT sensor with domain walls. A current is then applied to a domain wall stopping structure arranged over at least one portion of the MT sensor, and the working magnetic field (i.e., the magnetic field generated by a magnet mounted on the mechanical system) is rotated until the desired domain wall configuration is achieved. Once the desired domain wall configuration is achieved, the current applied to the domain wall stopping structure is stopped and the MT sensor is ready for use. The sensor can be initialized into a known state without needing to drive the mechanical system to a start or end position.

## Description

### Technical Field

The present disclosure relates to a magnetic sensor system. In particular, the present disclosure relates to a magnetic sensor system comprising a multi-turn sensor and a method of initializing the multi-turn sensor into a known state with a defined domain wall configuration.

### Background

Magnetic multi-turn (MT) sensors are commonly used in applications to monitor the number of times a device has been turned. An example is a steering wheel in a vehicle. Magnetic multi-turn sensors typically use magnetoresistive elements that are sensitive to an applied external magnetic field. The resistance of the magnetoresistive elements in multi-turn sensors can be changed by rotating a magnetic field within the vicinity of the sensor. Variations in the resistance of the magnetoresistive elements can be tracked to determine the number of turns in the magnetic field, which can be translated to a number of turns in the device being monitored.

The magnetic turn count information stored in the sensor is designed to match the physical turn count of the device the sensor is monitoring, and so the sensor is first set in a known magnetic state before it is used.

### Summary

The present disclosure provides magnetic sensor system that includes a magnetic sensing device comprising a magnetic multi-turn sensor, and a method of initializing the magnetic multi-turn sensor into a known state with a defined domain wall configuration ready for use. A strong magnetic field is first applied to fill the MT sensor with domain walls. A current is then applied to a domain wall stopping structure arranged over at least one portion of the MT sensor, and a rotating magnetic field (e.g., the magnetic field generated by a magnet mounted on the mechanical system) is applied until the desired domain wall configuration is achieved. Once the desired domain wall configuration is achieved, the current applied to the domain wall stopping structure is stopped and the MT sensor is ready for use. In doing so, the sensor can be initialized into a known state without needing to drive the mechanical system to a start or end position, and can also be initialized into a state suitable for the mechanical system being monitored.

A first aspect of the disclosure provides a method of initializing a magnetic multi-turn sensor, the multi-turn sensor comprising a length of magnetic track having a plurality of magnetoresistive sensing regions and arranged in at least one spiral configuration having a plurality of corner regions, the method comprising generating a first magnetic field in proximity to the multi-turn sensor such that domain walls are generated at a plurality of locations along the length of magnetic track, applying a current to at least one domain wall stopping structure arranged along at least one portion of the magnetic track, such that a further magnetic field is generated in the region of the at least one domain wall stopping structure; and applying a rotating magnet field in proximity to the multi-turn sensor, such that the domain walls are caused to propagate around the length of magnetic track, wherein one or more domain walls are annihilated in the region of the at least one domain wall stopping structure.

As such, a strong magnetic field is first applied to fill the sensor with domain walls. A current is then applied to the at least one domain wall stopping structure arranged along the magnetic track to create a localised magnetic field in those regions. An external magnetic field is then rotated to move the domain walls around the sensor. As the domain walls propagate around the sensor, some of the domain walls annihilated as they reach the domain wall stopping structure due to the localised magnetic field. This can be done until the desired configuration of domain walls (i.e., number of domain walls and position within the sensor) is achieved. In this way, the sensor can be initialized into a known state with a defined domain wall configuration without needing to drive the mechanical system to a start or end position, with the domain wall configuration instead being adapted to the current position of the mechanical system.

It will be appreciated that the length magnetic track may comprise a magnetoresistive material (e.g., a GMR or TMR material) or a ferromagnetic material. In cases where the magnetic track is formed from a magnetoresistive material, the multi-turn sensor may comprise a plurality of contacts for electrically connecting the magnetoresistive material, such that a plurality of magnetoresistive sensing elements connected in series are defined by said contacts to thereby provide the plurality of magnetoresistive sensing regions. In cases where the magnetic track is formed from a ferromagnetic material, the multi-turn sensor may comprise a plurality of magnetic tunnel junctions for electrically connecting the magnetic track, such that each of the plurality of magnetoresistive sensing regions is defined by at least one magnetic tunnel junction. More specifically, in some arrangements, each of the plurality of magnetoresistive sensing regions may be defined by a pair of magnetic tunnel junctions and a section of magnetic track therebetween. In other arrangements, each of the plurality of magnetoresistive sensing regions may be defined by a magnetic tunnel junction, an electrical contact and a portion of magnetic track therebetween.

The field strength of the further magnetic field generated by the at least one domain wall stopping structure may be such that domain walls are prevented from propagating past the at least one domain wall stopping structure. That is to say, the magnetic field generated by the current applied to the domain wall stopping structure is strong enough that domain walls become pinned in the region of the domain wall stopping structure. By preventing the domain walls propagating past the domain wall stopping structure, a domain wall may be held in place until a second domain wall arrives at the domain wall stopping structure and the two domain walls annihilate each other.

The method may further comprise stopping the current applied to the at least one domain wall stopping structure when a single domain wall or a single domain wall pair is present in the multi-turn sensor. By maintaining a single domain wall or domain wall pair, the position of the single domain wall or domain wall pair may then be monitored to measure the rotation of an external magnetic field.

Alternatively, the method may further comprise stopping the current applied to the at least one domain wall stopping structure when a plurality of domain walls having a defined configuration is present in the multi-turn sensor. That is to say, a defined pattern of domain walls can be written into the multi-turn sensor. For example, the defined configuration may comprise a certain number of domain walls arranged at a given set of positions around the sensor. This defined configuration may correspond to the domain wall configuration expected for the current position of the mechanical system. For example, if the mechanical system is at a position corresponding to 2 full turns, the defined configuration may comprise the number of domain walls and their position around the sensor that would be expected at this turn count. In doing so, the sensor can be initialized ready for use at that position without needing to drive it to the start or end point. Additionally, by providing a defined pattern of domain walls around the sensor, this pattern can be used to detect accidental domain wall pinning or domain wall nucleation, in which case a different pattern of domain wall propagation would be detected.

In some arrangements, the at least one domain wall stopping structure may be arranged along one of the magnetoresistive sensing regions. Alternatively, the domain wall stopping structure may be arranged along a portion of the magnetic track that does not define a sensing region.

The at least one domain wall stopping structure may comprise a plurality of domain wall stopping structures. The sensor can be thereby initialized into a state corresponding to a given turn count by activating the plurality of domain wall stopping structures in predetermined order to get a desired domain wall configuration for the given turn count from a single rotation of the magnetic field. In such cases, each domain wall stopping structure of the plurality of domain wall stopping structures may be arranged on respective portions of the magnetic track. For example, each domain wall stopping structure may be arranged on one of the plurality of magnetoresistive sensing regions. In this way, each of the domain wall stopping structures may act on a respective sensing region, thereby allowing greater control within the sensor.

In some arrangements, the at least one domain wall stopping structure may comprise a first domain wall stopping structure arranged on a first side of the at least one spiral, and a second domain wall stopping structure arranged on a second side of the at least one spiral. For example, a first domain wall stopping structure may be arranged on a vertical side of the sensor spiral and a second domain wall stopping structure may be arranged on a horizontal side of the sensor spiral. Alternatively, both the first and the second domain wall stopping structures may be arranged on respective parallel sides of the sensor spiral.

The at least one domain wall stopping structure may comprise an electrical conductor. For example, the domain wall stopping structure may comprise a length of electrical conductor formed of any suitable non-ferromagnetic, electrically conductive material such as Gold, Copper, Tantalum, Tungsten, Tungsten-titanium, Aluminium or an alloy comprising Aluminium and Copper.

The electrical conductor may comprise one or more narrowed portions arranged above or below a respective portion of magnetic track. That is to say, the electrical conductor may be a length of electrically conducting material that is narrowed in the region of a portion of the magnetic track. In some examples, the electrical conductor may be placed approximately 0.1 to 8 micrometres above or below the MT sensor. By providing narrowed portions above or below the respective portions of the magnetic track, the applied current will generate a strong, localised magnetic field in the region of the narrowed portions.

In some arrangements, generating the first magnetic field may comprise applying a current to at least one electrical conductor arranged in or on a substrate on which the multi-turn sensor disposed.

In other arrangements, generating the first magnetic field may comprise applying a current to a conductor extending between at least two opposing corner regions of the at least one spiral.

In other arrangements, generating the first magnetic field may comprise moving a magnet in an axial direction towards the multi-turn sensor.

As such, the first magnetic field may be generated in a number of suitable ways, provided the first magnetic field is strong enough to nucleate domain walls in the magnetic track.

A further aspect of the disclosure provides a magnetic sensor system, comprising a magnetic sensing device at least comprising a magnetic multi-turn sensor, wherein the magnetic multi-turn sensor comprises a length of magnetic track having a plurality of magnetoresistive sensing regions and arranged in at least one spiral configuration having a plurality of corner regions, a magnet mounted on a rotatable shaft, the magnet being positioned a first distance from the magnetic sensing device such that the magnetic multi-turn sensor is operable to measure a number of turns of a first magnetic field generated by the magnet, an initialization mechanism operable to generate domain walls at a plurality of locations along the length of magnetic track, and at least one domain wall stopping structure arranged along at least one portion of the magnetic track, wherein the domain wall stopping structure is configured to generate a further magnetic field when a current pulse is applied thereto, the field strength of the further magnetic field being such that domain walls are prevented from propagating past the at least one domain wall stopping structure.

In some arrangements, the at least one domain wall stopping structure may be arranged along one of the magnetoresistive sensing regions. Alternatively, the domain wall stopping structure may be arranged along a portion of the magnetic track that does not define a sensing region.

The at least one domain wall stopping structure may comprise a plurality of domain wall stopping structures. In such cases, each domain wall stopping structure of the plurality of domain wall stopping structures may be arranged on respective portion of the magnetic track. For example, each domain wall stopping structure may be arranged on one of the plurality of magnetoresistive sensing regions.

In some arrangements, the at least one domain wall stopping structure may comprise a first domain wall stopping structure arranged on a first side of the at least one spiral, and a second domain wall stopping structure arranged on a second side of the at least one spiral. For example, a first domain wall stopping structure may be arranged on a vertical side of the sensor spiral and a second domain wall stopping structure may be arranged on a horizontal side of the sensor spiral. Alternatively, both the first and the second domain wall stopping structures may be arranged on respective parallel sides of the sensor spiral.

In some arrangements, the at least one domain wall stopping structure may comprise an electrical conductor. For example, the domain wall stopping structure may comprise a length of electrical conductor formed of any suitable non-ferromagnetic, electrically conductive material such as Gold, Copper, Tantalum, Tungsten, Tungsten-titanium, Aluminium or an alloy comprising Aluminium and Copper.

The electrical conductor may comprise one or more narrowed portions arranged above or below a respective portion the magnetic track. That is to say, the electrical conductor may be a length of electrically conducting material that is narrowed in the region of a portion of the magnetic track. In some examples, the electrical conductor may be placed approximately 2-8 micrometres above or below the MT sensor.

In some arrangements, the length magnetic track may comprise a magnetoresistive material (e.g., a GMR or TMR material). In such cases, the multi-turn sensor may comprise a plurality of contacts for electrically connecting the magnetoresistive material, such that a plurality of magnetoresistive sensing elements connected in series are defined by said contacts to thereby provide the plurality of magnetoresistive sensing regions.

In other arrangements, the length of magnetic track may comprise a ferromagnetic material. In such cases, the multi-turn sensor may comprise a plurality of magnetic tunnel junctions for electrically connecting the magnetic track, such that each of the plurality of magnetoresistive sensing regions is defined by at least one magnetic tunnel junction. More specifically, in some arrangements, each of the plurality of magnetoresistive sensing regions may be defined by a pair of magnetic tunnel junctions and a section of magnetic track therebetween. In other arrangements, each of the plurality of magnetoresistive sensing regions may be defined by a magnetic tunnel junction, an electrical contact and a portion of magnetic track therebetween.

The initialization mechanism may comprise at least one electrical conductor arranged in or on a substrate on which the multi-turn sensor disposed, wherein the at least one electrical conductor may be configured to generate a further magnetic field when a current pulse applied thereto, such that domain walls are generated at a plurality of locations along the length of magnetic track. For example, the at least one electrical conductor may be embedded within the substrate, to thereby provide an initialization mechanism without increasing the overall size of the sensor package.

In other arrangements, the initialization mechanism may comprise at least one electrical conductor extending between at least two opposing corner regions of the at least one spiral. A current pulse may then be applied to the at least one electrical conductor to thereby generate a magnetic field that is strong enough to generate domain wall pairs in the corner regions of the spiral. In cases where the initialization device comprises an electrical conductor extending between at least two opposing corner regions, the electrical conductor of the initialization mechanism may also be configured to function as a domain wall stopping structure.

In further arrangements, the initialization mechanism may be a mechanism configured to move the magnet and the rotatable shaft in an axial direction towards the magnetic sensing device, such that when the magnet is at a second distance from the magnetic sensing device, domain walls are generated at a plurality of locations along the length of magnetic track by the magnetic field generated by the magnet. As such, by moving the magnet relative to the magnetic sensing device, the magnetic field strength experienced by the magnetic sensing device may be varied.

The magnetic multi-turn sensor may be a giant magnetoresistive (GMR) or a tunnel magnetoresistive (TMR) based multi-turn sensor.

Another aspect of the disclosure provides a magnetic sensor arrangement, comprising a magnetic sensing device at least comprising a magnetic multi-turn sensor, wherein the magnetic multi-turn sensor comprises a plurality of magnetoresistive sensing elements connected in series and arranged in at least one spiral configuration having a plurality of corner regions, and at least one domain wall stopping structure arranged along at least one of the plurality of magnetoresistive sensing elements, wherein the domain wall stopping structure is configured to generate a magnetic field when a current pulse is applied thereto, the field strength of the magnetic field being such that domain walls are prevented from propagating past the at least one domain wall stopping structure.

### Brief Description of the Drawings

The present disclosure will now be described by way of example only with reference to the accompanying drawings in which:
Figure 1 is an example of a magnetic sensor system in accordance with embodiments of the disclosure;
Figure 2 is an example of a magnetic multi-turn sensor in accordance with embodiments of the disclosure;
Figure 3 illustrates a method of initializing a magnetic multi-turn sensor into a known state in accordance with embodiments of the disclosure;
Figures 4A-B illustrate a further method of initializing a magnetic multi-turn sensor into a known state in accordance with embodiments of the disclosure
Figure 5 illustrates a further method of initializing a magnetic multi-turn sensor into a known state in accordance with embodiments of the disclosure;
Figure 6 illustrates an example of a domain wall stopping structure in accordance with embodiments of the disclosure;
Figure 7 illustrates use of a domain wall stopping structure in accordance with embodiments of the disclosure;
Figures 8A-D further illustrate use of a domain wall stopping structure in accordance with embodiments of the disclosure;
Figure 9 illustrates a further example of a domain wall stopping structure in accordance with embodiments of the disclosure;
Figure 10 illustrates a further example of a domain wall stopping structure in accordance with embodiments of the disclosure;
Figure 11 illustrates a further example of a domain wall stopping structure in accordance with embodiments of the disclosure;
Figure 12 illustrates a further example of a domain wall stopping structure in accordance with embodiments of the disclosure;
Figure 13 is a flow diagram illustrating a method of initializing a magnetic multi-turn sensor in accordance with embodiments of the present disclosure;
Figure 14 illustrates a further example of a magnetic multi-turn sensor with a domain wall stopping structure in accordance with embodiments of the disclosure;
Figure 15 further illustrates part of the magnetic multi-turn sensor shown in Figure 14.

### Detailed Description

Magnetic multi-turn sensors can be used to monitor the turn count of a rotating shaft. To do this, a magnet is typically mounted to the end of the rotating shaft, the multi-turn sensor being sensitive to the rotation of the magnetic field as the magnet rotates with the shaft. Such magnetic sensing can be applied to a variety of different applications, such as automotive applications, medical applications, industrial control applications, consumer applications, and a host of other applications which require information regarding a position of a rotating component.

For counting the number of turns, an xMR multi-turn sensor, typically, giant magnetoresistive (GMR) or tunnel magnetoresistive (TMR), based on domain wall propagation in an open or closed loop spiral is used. The multi-turn sensor may then be used in conjunction with an xMR angle sensor (also referred to as a single turn sensor) for determining the angular position of the rotating shaft within each 360° turn.

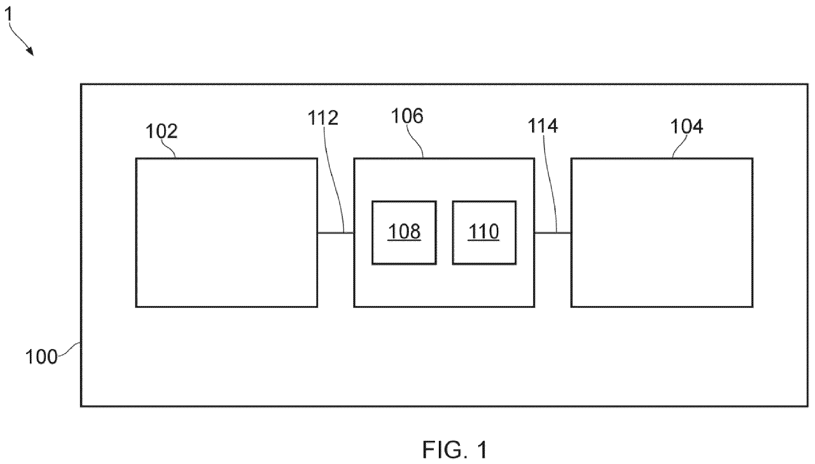

Figure 1 illustrates a schematic block diagram of an example magnetic sensor system 1 that includes an xMR multi-turn (MT) sensor 102. The magnetic sensor system 1 may also include a magnetic single turn (ST) sensor 104, which may be an anisotropic magnetoresistive (AMR), giant magnetoresistive (GMR) or tunnel magnetoresistive (TMR) based position sensor, although it will be appreciated that the magnetic sensor system 1 may be implemented without the ST sensor 104 or with a different type of magnetic angle sensor.

The sensor system 1 also comprises a processing circuit 106, and an integrated circuit 100 on which the MT sensor 102, the ST sensor 104 and processing circuit 106 are disposed. The processing circuit 106 receives signals S_{MT} 112 from the MT sensor 102 and processes the received signals to determine that the turn count using a turn count decoder 108, which will output a turn count representative of the number of turns of an external magnetic field (not shown) rotating in the vicinity of the MT sensor 102. Similarly, the processing circuit 106 may also receive signals S_{ST} 114 from the ST sensor 104 and process the received signals using a position decoder 110 to output an angular position of the external magnetic field.

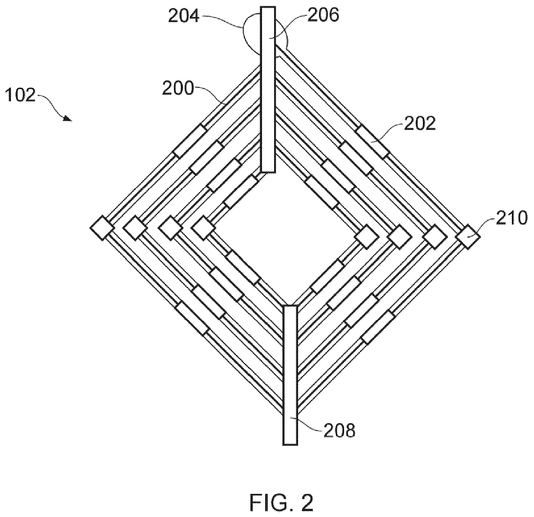

Figure 2 shows an example of a magnetic track layout representation of the magnetic MT sensor 102 comprising a plurality of magnetoresistive elements 202 that may be used in accordance with the embodiments of the present disclosure. In the example of Figure 2, the magnetic track 200 is a giant magnetoresistive (GMR) track that is physically laid out in an open loop spiral configuration, although it will be appreciated that the sensor may also be formed from tunnel magnetoresistive (TMR) material. As such, the magnetic track 200 has a plurality of segments formed of the magnetoresistive elements 202 arranged in series with each other. The magnetoresistive elements 202 act as variable resistors that change resistance in response to a magnetic alignment state. One end of the magnetic track 200 may be coupled to a domain wall generator (DWG) 204. In this respect, it will be appreciated that the DWG 204 may be coupled to either end of the magnetic track 200. The DWG 204 generates domain walls in response to rotations in an external magnetic field, or the application of some other strong external magnetic field beyond the operating magnetic window of the sensor 102. These domain walls can then be injected into the magnetic track 200. As the magnetic domain changes, the resistance of the GMR elements 202 will also change due to the resulting change in magnetic alignment.

In order to measure the varying resistance of the GMR elements 202 as domain walls propagate around the spiral, the magnetic track 200 is electrically connected to a supply voltage VDD 206 and to ground GND 208 to apply a voltage between a pair of opposite corners. The corners halfway between the voltage supplies are provided with electrical connections 210 so as to provide half-bridge outputs. As such, the multi-turn sensor 102 comprises multiple Wheatstone bridge circuits, with each half-bridge 210 corresponding to one half-turn or 180° rotation of an external magnetic field. Measurements of voltage at the electrical connections 210 can thus be used to measure changes in the resistance of the GMR elements 202, which is indicative of changes in the magnetic alignment of the free layer. In the case of a magnetic multi-turn sensor comprising a magnetic track formed from a TMR material, each sensing region (i.e., corresponding to element 202 in Figure 2) may be defined by two or more electrical contacts for performing current-in-plane tunnelling measurements, such as that described in WO 2024/074460, which is hereby incorporated by reference in its entirety.

The example shown by Figure 2 comprises four spiral windings eight half-bridges 210, and is thus configured to count four turns of an external magnetic field. However, it will be appreciated that a multi-turn sensor may have any number of spiral windings depending on the number of GMR elements 202. In general, multi-turn sensors can count as many turns as spiral windings. It will also be appreciated that the GMR elements 202 may be electrically connected in any suitable way so as to provide sensor outputs representative of the changes in magnetic alignment state. For example, the GMR elements 202 may be connected in a matrix arrangement such as that described in US 2017/0261345, which is hereby incorporated by reference in its entirety. As a further alternative, each magnetoresistive element 202 may be connected individually, rather than in a bridge arrangement.

As described above, the magnetic turn count information stored in the MT sensor 102 is designed to match the physical turn count of the device the MT sensor 102 is monitoring, and so the MT sensor 102 must first be set in a known magnetic state before it can be used. Once this has been done, the MT sensor 102 will output a sequence of output signals as the mechanical system rotates that is indicative of the number of turns.

Typically, the initialization is carried out when the mechanical system is at its start or end position, as this is not always possible or easy to do when initializing the sensor in-situ. Likewise, this is not always suitable for some mechanical systems, for example, in situations where the functional "start point" (i.e., the start point for the user) is in the middle, such as a steering system or a servomotor. Additionally, it can also be useful to have a defined pattern of domain walls in the sensor, in order to detect and locate faults in the sensor.

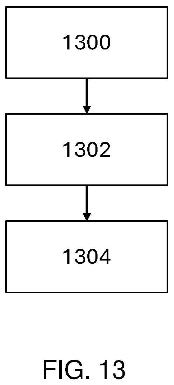

The present disclosure therefore provides a method of initializing a magnetic MT sensor into a known state with a defined domain wall configuration, as illustrated by the steps of Figure 13. In brief, the method comprises applying a strong magnetic field to fill the MT sensor with domain walls at step 1300, applying a current to a domain wall stopping structure arranged over at least one portion of the magnetic track at step 1302, and applying a rotating magnetic field (e.g., the magnetic field generated by a magnet mounted on the mechanical system) until the desired domain wall configuration is achieved at step 1304. Once the desired domain wall configuration is achieved, the current applied to the domain wall stopping structure is stopped and the MT sensor is ready for use. In doing so, the sensor can be initialized into a known state without needing to drive the mechanical system to a start or end position, and can also be initialized into a state suitable for the mechanical system being monitored.

As noted above, the first step 1300 of the method described herein is to fill the MT sensor entirely with domain walls by generating a first magnetic field in proximity to the multi-turn sensor. This can be done by a number of different methods, as will now be described.

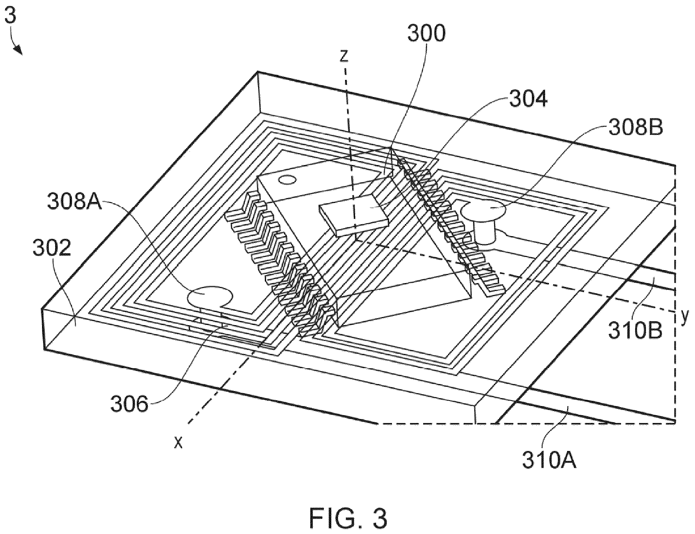

Figure 3 illustrates an example of a system 3 that may be used to fill the MT sensor with domain walls at step 1300. A magnetic sensor package 300 comprising a magnetic MT sensor 304 is provided. It will be appreciated that the magnetic sensor package 300 may contain the magnetic sensor system 1 shown in Figure 1, with the MT sensor 304 being the MT sensor 102 shown in Figures 1 and 2. It will thus be appreciated that Figure 3 shows only the magnetic MT sensor 304 for exemplary purposes, and that other features of the magnetic sensor package 300 have been omitted from the drawings. The magnetic sensor package 300 is positioned on substrate 302, for example, a printed circuit board (PCB), in which an electrical conductor, shown herein in the form of a wire 306, is integrated. In this example, the initialization wire 306 is arranged in planar coil configuration comprising two spirals, however, it will be appreciated that the initialization wire 306 may be arranged any suitable configuration provided the magnetic sensor package 300 is positioned adjacent to at least a portion of the initialization wire 306 for reasons that are explained below. It will also be appreciated that the initialization wire 306 may be replaced with a coil (e.g., a solenoid) arranged on the opposite side of substrate 302 to that of the sensor package 300.

To initialize the MT sensor 304, a magnetic field pulse is generated by applying a strong current pulse to the initialization wire 306. In this respect, the initialization wire 306 comprises two connection terminals 308A-B that are connected to two connecting wires 310A-B for connecting to a power supply (not shown). The magnetic field generated by the initialization wire 306, plus any magnetic field already being generated, for example, by the rotating magnet of the mechanical system (not shown), results in a magnetic field that is stronger than the upper limit of the operating window of the MT sensor 304. For example, a 10 microsecond pulse of approximately 50A will result in a 25mT magnetic field. In practice, the superposition of the magnetic field generated by the nearby magnet of the mechanical system and the magnetic field generated by the current pulse in the wire 305 sum to generate a magnetic field that goes beyond the operating window of the MT sensor 304. This results in the magnetoresistive elements of the MT sensor 304 being nucleated with domain walls, thereby magnetising each of the windings of the sensor spiral into the same magnetic state. As such, this arrangement provides an effective, but easy to manufacture, device for initializing a MT sensor 304 that can be implemented once the magnetic sensor package 300 has already been installed in a system.

It will of course be appreciated however that the initialization may still be performed in cases where a magnet is not within the vicinity of the sensor system 3, using the magnet field generated by the initialization wire 306. In such cases, the current pulse applied to the initialization wire 306 is configured to be strong enough to generate a magnetic field that is above the upper limit of the operating window of the MT sensor 304, whereby domain wall nucleation occurs.

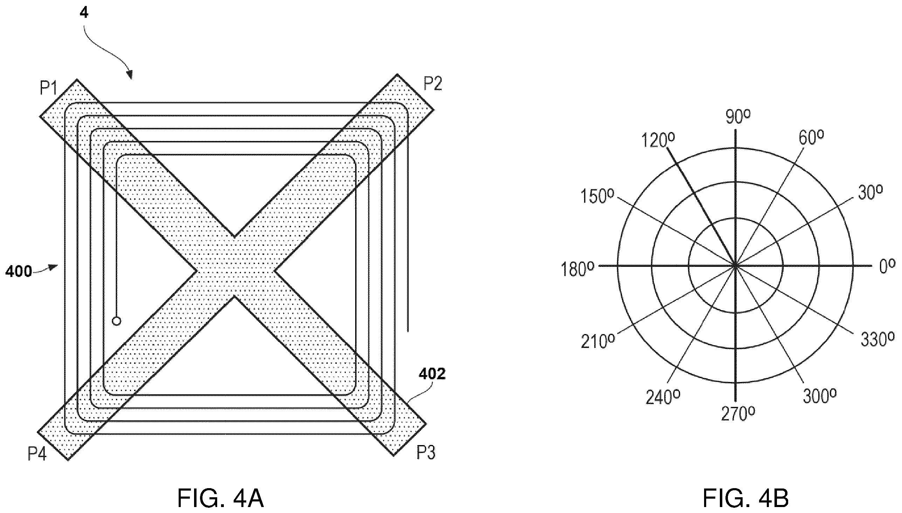

Figure 4A illustrates a further example of a system 4 that may be used to fill the MT sensor with domain walls at step 1300, the system 4 comprising a MT sensor 400 and initialization device 402. As described with reference to Figure 2, the MT sensor 400 is in the form of a magnetoresistive track that is physically laid out in an open loop spiral configuration. The initialization device 402 is an "X" or "cross" shaped conductor that is located in close proximity the MT sensor 400 such that the arms of the initialization device 402 having terminals P1-P4 are positioned over (or below) the corners of the spiral. Typically, the initialization device 402 is placed approximately 0.1 to 8 micrometres above or below the MT sensor 400 and is made of a non-ferromagnetic material such as Gold, Copper, Aluminium or an alloy comprising Aluminium and Copper. Whilst the initialization device 402 is shown as an X-shaped portion of material having a planar upper surface, it will be appreciated that the initialization device 402 may be in any suitable form, for example, a wire or the like, provided it only extends over the corner regions of the MT sensor 400. Additionally, in some examples, the initialization device 402 may only extend over one pair of opposing corners. In some other embodiments, the initialization device 402 may extend over one or more corner regions and a portion of another region of the MT sensor 400.

The terminals P1-P4 may be electrically connected in any suitable way, for example, with terminals P1, P3 and P4 being connected to ground and P2 being connected to voltage supply. By connecting one terminal to the voltage supply, a lower resistance will be generated, and thus a larger current can be driven into the initialization device 402 with a lower voltage.

In use, a current is applied to one of these terminals P1-P4 so as to generate a magnetic field that is strong enough to generate domain pairs of domain walls in the corner regions of the sensor spiral. Typically, a current pulse is applied to generate a magnetic field strength in the range of 20mT to 40mT.

The direction in which current is applied to the conductor 402 will depend on the orientation of the external magnetic field of the system in which the sensor is installed, for example, the magnetic field generated by a magnet mounted on a rotating shaft. With reference to the polar coordinate system shown in Figure 4B, Table 1 below provides the direction that the current has to be applied to completely fill the MT sensor spiral with domain walls, depending on the direction of the external magnetic field, Bₑₓₜ.

**Table 1**

| **Magnetic Field Angle of Bₑₓₜ** | **Current Direction** |
|---|---|
| 0° - 90° | P1 → P3 |
| 90° - 180° | P4 → P2 |
| 180° - 270° | P3 → P1 |
| 270° - 360° | P2 → P4 |

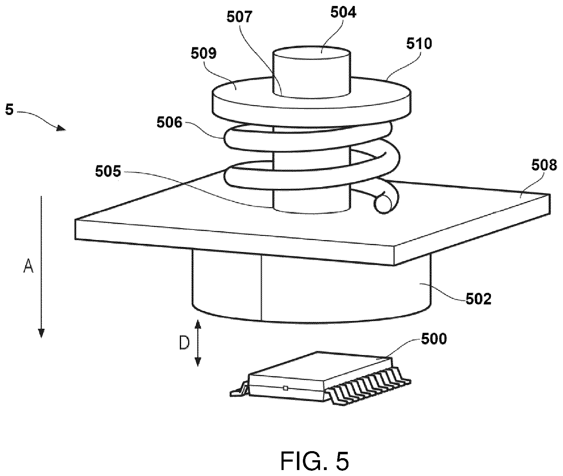

Figure 5 illustrates a further example of a system 5 that may be used to fill the MT sensor with domain walls at step 1300. A magnetic sensor package 500 comprising a magnetic MT sensor (not shown) is provided. It will again be appreciated that the magnetic sensor package 500 may contain the magnetic sensor system 1 shown in Figure 1, with the MT sensor being the MT sensor 102 shown in Figures 1 and 2. The magnetic sensor package 500 is placed below a magnet 502 mounted on the end of a rotatable shaft 504, which itself will be coupled to the mechanical system that is to be monitored. The magnet 502 is placed a first distance D above the magnetic sensor package 500, this first distance D being the working distance whereby the magnetic field strength experienced by the magnetic sensor package 500 at this distance is within the operating magnetic window in which the magnetic MT sensor will accurately output turn count information. The magnetic window is defined by a minimum magnetic flux density, Bmin, and a maximum magnetic flux density, Bmax. Below Bmin, domain wall propagation can fail, causing the turn count information to be corrupted. Above Bmax, the domain walls can be nucleated, and so in operation, the sensor will contain false turn count information.

The system 5 is provided with an initialization mechanism that is configured so as to move the magnet 502 and the shaft 504 in an axial direction (denoted by arrow A) towards the sensor package 500. In doing so, the magnetic field experienced by the magnetic sensor package exceeds the Bmax of the magnetic MT sensor, thereby filling the MT sensor spiral with domain walls and magnetising the magnetoresistive elements into the initialized state. Once initialized, the magnet 502 is brought back to its starting position at the first distance D above the sensor package 500.

In this example, the initialization mechanism comprises a spring 506 positioned between a base plate 508 located just above the magnet 502 and an upper plate 510. The rotating shaft 504 is then threaded through respective holes 505, 507 in the centre of the base plate 508 and upper plate 510, the hole 505 in the base plate 508 being configured to allow the shaft 504 to rotate freely. The base plate 508 is fixed in place to some external structure (not shown) such that it cannot move in a rotational or axial direction, thereby providing an anchor for the initialization mechanism. In this respect, it will be appreciated that any suitable support structure held in a fixed axial position may be used to act as an anchor for the spring 506 and the upper plate 510. The upper plate 510 will be fixed to the rotating shaft 504 so that it can move with the shaft 504 in both a rotational and axial direction. In use, the upper plate 510 is pushed downwards towards the base plate 508 against the force of the spring 506, thereby compressing the spring 506 and pushing the magnet 502 down towards the sensor package 500 so as to increase the magnet field strength in the vicinity of the sensor package 500, and thereby initialize the MT sensor contained therein, as described above. Once the MT sensor has been initialized, the upper plate 510 is released, the spring 506 then biasing the upper plate 510, and thus the magnet 502 and shaft 504, back towards the starting position. In this respect, it will be appreciated that either the upper plate 510 or the shaft 504 may be pushed downwards against the force of the spring 506. For example, the shaft 504 may be driven axially from the end opposite to that shown in Figure 5. Alternatively, as another example, the upper plate 510 may be mechanically actuated by some means pushing against its upper surface 509. Similarly, whilst the upper plate 510 is shown as ring-shaped, it will also be appreciated that the upper plate 510 may be any suitable form for actuating the shaft 504 in the axial direction.

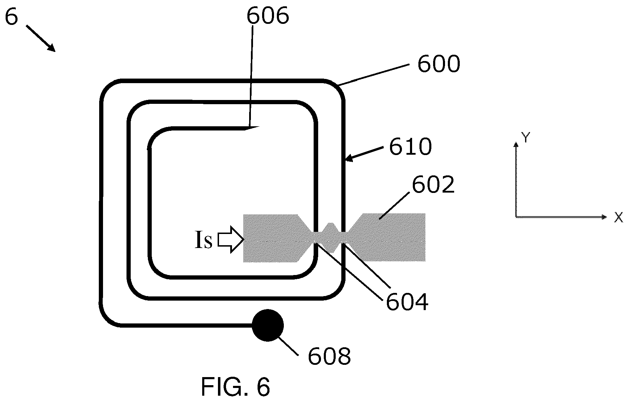

Once the MT sensor has been filled with domain walls, for example, using any of the methods described above, the next step 1302 is to apply to a current *Is* through at least one domain wall stopping structure 602 arranged along at least one portion of the magnetic track of the multi-turn sensor, such as that illustrated by Figure 6. As will be explained in more detail below, applying a current to the domain wall stopping structure 602 causes a further magnetic field to be generated in the region thereof.

Figure 6 shows a multi-turn sensor arrangement 6 comprising a length of magnetoresistive track 600 arranged in open loop spiral configuration to thereby define a multi-turn sensor, and a domain wall stopping structure 602. Whilst not shown, it will be appreciated that the magnetoresistive track 600 may be electrically connected in a similar way to that shown in Figure 2, to thereby form a plurality of magnetoresistive sensing elements (shown generally at 610), such that each "arm" of the sensor spiral 600 comprises a sensing element (also referred to herein as a "sensing region"). The sensor track 600 further comprises a domain wall generator 608 at a first end and a dead end 606 at the other end of the spiral.

As shown in Figure 6, the domain wall stopping structure 602 may be in the form of an electrical conductor placed above or below at least one portion of the magnetoresistive track 600, specifically, above or below one or more of the sensing elements 610 of the MT sensor 600, the domain wall stopping structure 602 having narrowed portions 604 in the regions of the sensing elements 610. In this respect, the narrowed portions 604 may comprise very narrow lengths of wire. In some examples, the domain wall stopping structure 602 may be placed approximately 0.1 to 8 micrometres above or below the MT sensor 600. The domain wall stopping structure 602 may be made of any suitable non-ferromagnetic, electrically conductive material such as Gold, Copper, Tantalum, Tungsten, Tungsten-titanium, Aluminium or an alloy comprising Aluminium and Copper. In the example of Figure 6, the domain wall stopping structure 602 is arranged over one side of the sensor 600, such that two narrowed portions 604 are provided over two parallel sensing elements 610. As will be described further below, it will be appreciated that the sensor 600 may be arranged in a spiral having any number of turns, and the domain wall stopping structure 602 may be arranged over any side of the sensor 600 and have narrowed portions 604 over any number of the sensing elements 610. It will also be appreciated that more than one domain wall stopping structure 602 may also be provided. The current *Is* will generate a strong magnetic field at the narrowed portions 604, which will be predominantly pointing in the direction in which the sensing element 610 extends.

For example, in Figure 6, the magnetic field generated by the domain wall stopping structure 602 will be in the Y direction.

As described above, the next step 1304 is to apply a rotating magnetic field in the vicinity of the sensor arrangement 6, for example, by rotating a magnet (which may be the magnet of the mechanical system), or linearly moving a bar magnet having multiple poles. In the latter case, a linear magnetic track with alternating north and south poles will create a rotating magnetic field as it moves in a linear direction relative to the sensor. As will be described further below, the rotating magnetic field causes the domain walls (i.e., those generated at step 1300) to propagate around the magnetoresistive sensing elements 610 of the sensor 600, wherein one or more of the domain walls are annihilated in the region of at the at least one domain wall stopping structure 602.

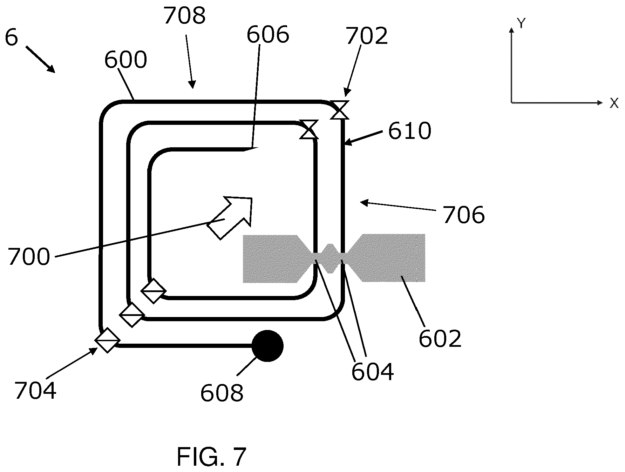

Figure 7 illustrates an example starting condition of the magnetic sensor 600, wherein the magnetoresistive track 600 has been filled with domain walls at a plurality of locations along its length, for example, using any of the methods described herein. To visualize the state, head-to-head (indicated generally in Figure 7 as 702) and tail-to-tail (indicated generally in Figure 7 as 704) domain walls are shown as double triangles, either pointing towards to away from each other. In this example, the current *Is* applied by the domain wall stopping structure 602 generates a magnetic field at the magnetoresistive elements 610 along the left vertical side (shown generally as 706) of the sensor spiral 600, the magnetic field pointing upwards (i.e., in the direction Y). The arrow 700 indicates the direction of the rotating magnetic field, which in this example is at an angle of 45 degrees. In Figure 7, the domain wall stopping structure 602 is shown arranged on a vertical side 706 of the sensor 600 however, it will be appreciated that the domain wall stopping structure 602 may be arranged on a horizontal side (such as that shown generally as 708) of the sensor 600.

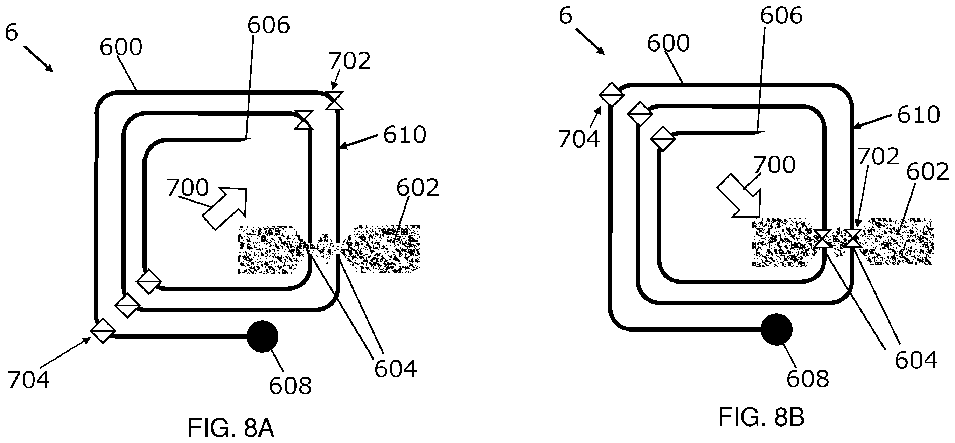

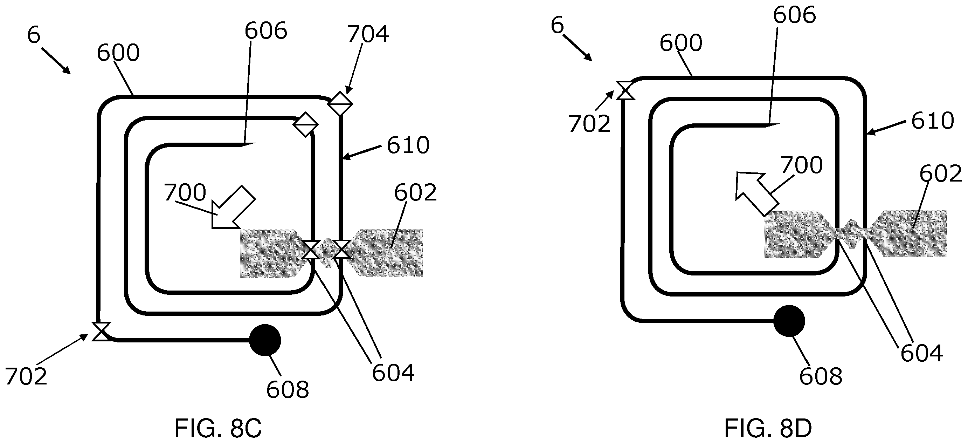

Figures 8A-D illustrate the removal of the domain walls from the multi-turn sensor 600 when the magnetic field 700 is rotated. Figure 8A shows the same starting condition as Figure 7. After rotating the magnetic field 700 by 90 degrees clockwise, as shown in Figure 8B, the domain walls 702, 704 begin to propagate around the sensor 600 in a clockwise direction, with two head-to-head domain walls 702 becoming trapped at the domain wall stopping structure 602 due to the applied current *Is* generating the stopping field. After another 90 degree rotation, as shown in Figure 8C, one tail-to-tail domain wall 704 disappears at the dead end 606 of the sensor 600 and two further tail-to-tail domain walls 704 are approaching the position of the trapped head-to-head domain walls 702, i.e., at the domain wall stopping structure 602. A new head-to-head domain wall 702 is also generated by the domain wall generator 608. Finally, with a further 90 degree rotation, as shown in Figure 8D, the two head-to-head domain walls 702 trapped at the domain wall stopping structure 602 are annihilated by the incoming tail-to-tail domain walls 704. Consequently, only one domain wall 702 (or a desired number of domain walls) remains that was newly created by the domain wall generator 608 in the previous rotation.

Once only one domain wall is left, or the desired number of domain walls are left, the current *Is* applied to the domain wall stopping structure 602 is stopped to allow future domain walls to pass this area without being trapped in that region.

Using the above method, the multi-turn sensor 600 can be initialized into a known state with a defined domain wall configuration without needing to drive the mechanical system to a start or end position. Instead, the domain wall configuration can be adapted so that it aligns with the current position of the mechanical system. That is, the expected domain wall configuration for the current position of the mechanical system can provided so that the sensor 600 is ready to count from that position. For example, if the mechanical system is at a position corresponding to three turns in a clockwise direction, the multi-turn sensor 600 can be initialized into a state corresponding to three turns. To achieve this, the domain wall stopping structure 602 can be arranged on the sensor 6 in a particular way according to the number of windings in the sensor 6 and the number of turns at which the sensor 600 is to be initialized. For example, if the sensor spiral 600 has six windings with a domain wall generator 608 arranged on the outside of the spiral, and the sensor 600 needs to be initialized into a state corresponding to three turns, domain wall stopping structures 602 will be placed over (or under) the three inner windings of the sensor 600.

Whilst the above example shows the rotation of the magnetic field 700 is a clockwise direction, it will be appreciated that the same process may be carried out by rotating the magnetic field 700 in a counter-clockwise direction. Similarly, the same process may be carried out in cases where the domain wall generator 608 is provided in the centre of the sensor 600 or the sensor 600 is wound in the opposite direction.

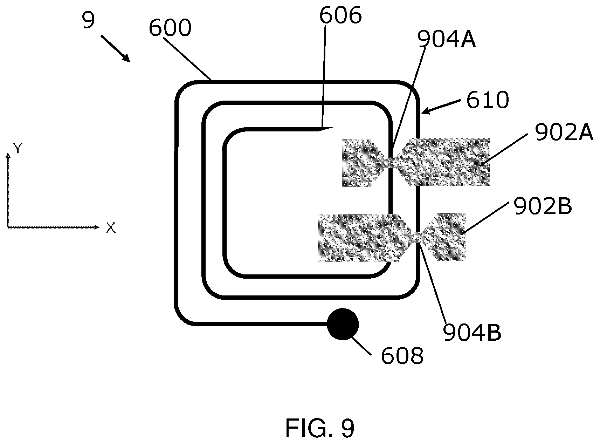

Figures 9 to 11 illustrate further examples of multi-turn sensor arrangements comprising a magnetic multi-turn sensor and one or more domain wall stopping structures in accordance with the disclosure. In each of the examples provided, the multi-turn sensor 600 is shown as being the same as that shown in Figures 6, 7 and 8A-D, however, it will be appreciated that a multi-turn sensor having a different configuration (e.g., different number of windings, different winding direction etc) may be used.

In Figure 9, a multi-turn sensor arrangement 9 comprising two domain wall stopping structures 902A, 902B that act on different turns of the sensor 600 is provided. A first domain wall stopping structure 902A is provided along one side the sensor 600, the first domain wall stopping structure 902A having one narrowed portion 904A arranged over one of the sensing elements 610 (e.g., on an inner turn of the sensor 600). A second domain wall stopping structure 902B is provided along the same side of the sensor 600, the second domain wall stopping structure 902B having a narrowed portion 904B arranged over a different sensing element 610 of that side of the sensor 600 (e.g., on the outer turn). The current applied to each of these domain wall stopping structures 902A, 902B acts on its respective sensing element 610.

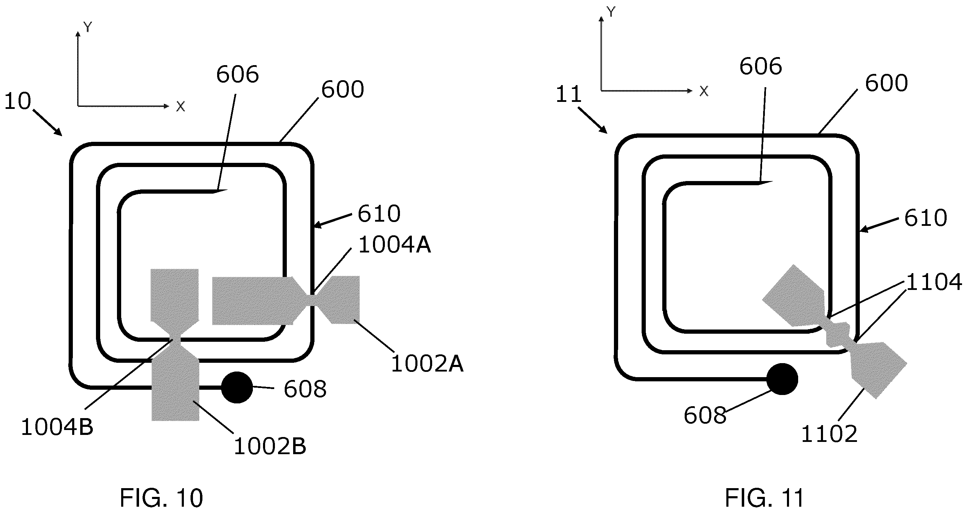

In Figure 10, a multi-turn sensor arrangement 10 comprising two domain wall stopping structures 1002A, 1002B is again provided, but on different sides of the sensor 600. A first domain wall stopping structure 1002A is provided along one side the sensor 600, the first domain wall stopping structure 1002A having one narrowed portion 904A arranged over just one of the sensing elements 610. A second domain wall stopping structure 1002B is then provided along a different side of the sensor 600, in this case along a horizontal side (i.e., aligned with the X-direction), the second domain wall stopping structure 1002B having a narrowed portion 1004B arranged over a single horizontal sensing element 610. The current applied to the first domain wall stopping structure 1002A will generate a magnetic field in the Y-direction, whilst the current applied to the second domain wall stopping structure 1002B will generate a magnetic field in the X-direction.

By having multiple separate domain wall stopping structures 1002A, 1002B on different spiral arms of a multi-turn sensor 600 that can be independently activated (e.g., in a sequence), a defined domain wall pattern can be written into the sensor 600. For example, one domain wall stopping structure 1002A may be activated at a first time, with one or more domain walls being annihilated in that region of the sensor 600, and then a further domain wall stopping structure 1002B activated a second time, with one or more domain walls being annihilated in that region of the sensor 600, to thereby provide a defined pattern of domain walls around the sensor 600. In doing so, this pattern could be used to detect accidental domain wall pinning or domain wall nucleation, in which case a different pattern of domain wall propagation would be detected. For example, in the case of a 40 turn sensor, a domain wall stopping structure may be used to remove 20 domain wall pairs between the 20^{th} winding (counting from the domain wall generator) and the dead end of the spiral, such that domain wall pairs only remain on the 1^{st} to 20^{th} windings. Two further domain wall pairs may then be removed using domain wall stopping structures on the 17^{th} and 19^{th} winding to provide two domain wall "gaps" in the domain wall pairs that remain in the sensor spiral. The position of the leading domain wall in the 20^{th} winding and the two domain wall gaps can then be monitored to detect any problems in the domain wall propagation that would lead to an incorrect error reading. If a domain wall pair is accidently annihilated, this double gap pattern will change.

In doing so, the way in which the pattern changes gives information as to what happened to cause this change, so that the correct count state can still be determined.

This also enables the domain wall configuration to be tailored to the mechanical state of the system to be monitored with the sensor. For example, assuming every spiral arm has its own domain wall stopping structure that can be activated independently, every domain wall state possible could be written into the sensor after one rotation of the mechanical system. This could therefore be used to place the sensor spiral into the desired state with one rotation to align with the mechanical system to be monitored. This can be particularly useful in cases where the mechanical system has been assembled in a random way, so that the mechanical turn count is in an arbitrary state. The sensor can thus be initialized into a state corresponding to this turn count by activating the domain wall stopping structures used to get the desired domain wall configuration for that turn count from a single rotation of the magnetic field.

Whilst the above examples show domain wall stopping structures provided along the straight portions of the sensor 600 (i.e., along the sensing elements 610), it will be appreciated that a domain wall stopping structure 1102 may also be provided in the corner regions, as shown by the multi-turn sensor arrangement 11 in Figure 11. In such cases, the magnetic field generated when a current is applied to the domain wall stopping structure 1102 will be in a direction at angle of 45 degrees relative to the Y-direction. Similarly, the arrangement shown in Figure 4A may also be used as a domain wall stopping structure. For example, the initialization device 402 may be adapted to have narrowed portions in the regions of the sensing elements, such that it can be used to fill the sensor spiral 400 with domain walls and then used as a domain wall stopping structure. It will however be appreciated that initialization device 402 may be used as a domain wall stopper as shown in Figure 4A, or with narrowed portions provided in a subset of the corner regions.

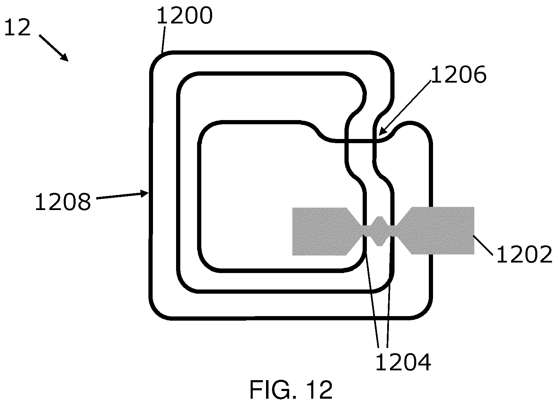

Whilst the above examples describe a MT sensor having an open loop configuration, it will be appreciated that methods described herein may also be applied to MT sensors having a closed loop configuration, as illustrated by the multi-turn sensor arrangement 12 shown in Figure 12. In this example, the sensor 1200 is arranged in a closed loop configuration, wherein one or more sensing elements (shown generally at 1208) cross over each other at a crossing 1206. As before, a domain wall stopping structure 1202 is provided having one or more narrowed portions 1204 arranged over one or more of the sensing elements 1208. Again, it will be appreciated that any number of domain wall stopping structures 1202 may be provided on any side of the sensor 1200, as described above. The domain wall stopping structure 1202 is again used to provide a defined domain wall configuration. In a closed-loop sensor such as that shown in Figure 12, after the sensor spiral has been filled with domain walls, it is desirable to annihilate at least one domain wall pair to ensure that the sensor read-out is not repeated after only one turn of the magnetic field to be monitored.

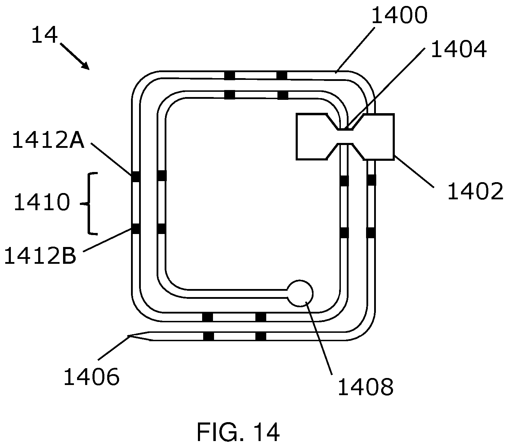

Figure 14 provides a further example of a TMR-based multi-turn sensor arrangement 14 comprising a domain wall stopping structure 1404. In this example, the multi-turn sensor arrangement 14 comprises a length of magnetic track 1400 arranged in an open loop spiral configuration to thereby define a multi-turn sensor, and at least one domain wall stopping structure 1402. In this respect, the magnetic track 1400 may be formed from any suitable ferromagnetic or soft magnetic material, such as cobalt iron (CoFe), cobalt iron boron (CoFeB) or nickel iron (NiFe). As with previous examples, the sensor arrangement 1400 comprises a domain wall generator 1408 at one end of the spiral and a dead end 1406 at the other end of the spiral. In this example, the domain wall generator 1408 is shown as being in the centre of the spiral, however, it will be appreciated that the domain wall generator 1408 may be arranged on the outside of the spiral.

In this example, the multi-turn sensor arrangement 14 comprises a plurality of sensing regions 1410. Each sensing region 1410 may be defined by a pair of magnetic tunnel junctions 1412A-B and a portion of magnetic track 1400 therebetween, wherein the magnetic tunnel junctions 1412A-B may be arranged above or below the magnetic track 1400. In another arrangement, one of the magnetic tunnel junctions 1412A-B shown in Figure 14 may be replaced with a single electrical contact, such that the sensing region 1410 is defined by a magnetic tunnel junction, an electrical contact and a portion of magnetic track 1400 therebetween.

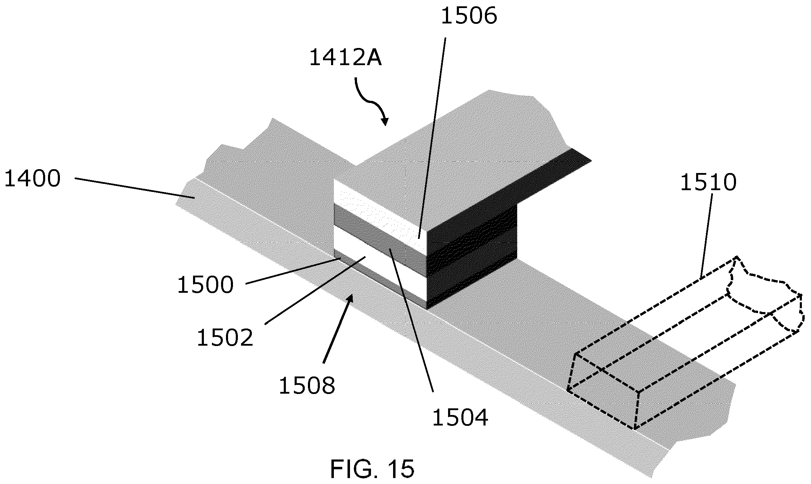

Figure 15 illustrates the structure of one of the magnetic tunnel junctions 1412A, though it will be appreciated that this applies to each of the magnetic tunnel junctions shown in Figure 14. In this example, the magnetic tunnel junction 1412A sits on top of the magnetic track 1400 and comprises a tunnel barrier layer 1500, a ferromagnetic reference layer 1502, an antiferromagnetic pinning layer 1504 and a top electrode 1506. In cases where the magnetic tunnel junction 1412A is provided below the magnetic track 1400, the top electrode 1506 will be replaced with a bottom electrode, with the other layers extending from the magnetic track 1400 is substantially the same order. This is referred to as a "bottom pinned" arrangement, whereas Figure 15 illustrates a "top pinned" arrangement.

The magnetisation direction of the ferromagnetic reference layer 1502 is pinned in a fixed reference direction by the antiferromagnetic pinning layer 1504. As discussed above, the magnetic track 1400 is formed from a ferromagnetic or soft magnetic material, and thus the magnetisation of the track 1400 is free to change direction in the presence of an external magnetic field, and thus the region of the magnetic track 1400 directly below the tunnel barrier 1500 (shown generally as 1508) effectively form a tunnel magnetoresistive stack in the region of the magnetic tunnel junction 1412, with the magnetic track 1400 acting as a "free layer". If the magnetisations of the reference layer 1502 and the magnetic track 1400 are in a parallel orientation, it is more likely that electrons will tunnel through the insulating material used as the tunnel barrier layer 1500 than if they are in an antiparallel orientation. Consequently, as the magnetisation direction of the magnetic track 1400 changes, the sensor will output one of two states of electrical resistance (low resistance or high resistance), depending on whether the magnetisations of the reference layer 1502 and the magnetic track 1400 are in a parallel or antiparallel orientation. In this respect, the magnetic state (i.e., the magnetisation) of each sensing region 1410 can be determined by measuring the resistance between the top electrodes 1506 of each pair or magnetic tunnel junctions 1412A-B to thereby determine the resistance change through the tunnel barrier layer 1500 in the presence of an external rotating magnetic field. For example, if the magnetisation of the magnetic track 1400 is antiparallel with that of the reference layer 1502, a high resistance is output. When the magnetisation direction of the magnetic track 1400 is parallel with that of the reference layer 1502, a low resistance is output.

In an alternative arrangement, as described above, one of the magnetic tunnel junctions 1412A-B shown in Figure 14 may be replaced with a single electrical contact (as illustrated by the dashed feature shown at 1510), which is electrically connected to the magnetic track 1400. In this arrangement, the magnetic state (i.e., the magnetisation) of each sensing region 1410 can be determined by measuring the resistance between the top electrode 1506 of the magnetic tunnel junction 1412A and the electrical contact 1510 to thereby determine the resistance change through the tunnel barrier layer 1500 of the magnetic tunnel junction 1412A in the presence of an external rotating magnetic field.

It will be appreciated that the length of magnetic track between a pair of magnetic tunnel junctions 1412A-B, or between a magnetic tunnel junction 1412A and an electrical contact 1510, may be any suitable size. However, it will also be appreciated that the longer the distance between the two points at which resistance is measured, the harder it will be to measure the resistance change in the tunnel barrier 1500 as there will be more resistance through the magnetic track 1400.

As with previous examples, the domain wall stopper 1402 may be in the form of an electrical conductor placed above or below the magnetic track 1400, however, in this example, the domain wall stopper 1402 is placed outside of the sensing regions 1410 (i.e., not between pairs of magnetic tunnel junctions 1412A-B). As before, the domain wall stopping structure 1402 has a narrowed portion 1404 in the region of the magnetic track 1400, which may comprise very narrow lengths of wire and may be placed approximately 0.1 to 8 micrometres above or below the magnetic track 1400. Similarly, the domain wall stopping structure 1402 may be made of any suitable non-ferromagnetic, electrically conductive material such as Gold, Copper, Tantalum, Tungsten, Tungsten-titanium, Aluminium or an alloy comprising Aluminium and Copper. Whilst the domain wall stopping structure 1402 is shown as being arranged on one portion of the magnetoresistive track 1400, it will be appreciated that the domain wall stopping structure 1402 may be arranged on any side of the magnetic track 1400 and have narrowed portions 1404 over multiple portions of track 1400. It will also be appreciated that more than one domain wall stopping structure 1402 may also be provided.

The multi-turn sensor arrangement 1400 shown in Figure 14 may be initialised in substantially the same way as that described above, with reference to Figure 13. That is to say, at step 1300, the magnetic track 1400 is first filled with domain walls at a plurality of locations along the length of the magnetic track 1400 (e.g., in the corner regions), a current is then applied to the domain wall stopping structure 1402 at step 1302, and a rotating magnetic field is applied until the desired domain wall configuration is achieved at step 1304.

Whilst the open loop MT sensors described herein (e.g., Figures 6-11, 14) show a single domain wall generator, it will also be appreciated that they may be provided with no domain wall generators or with domain wall generators at both ends of the spiral. In case of no domain wall generators, no new domain walls are created, in which case, it is desirable to remove all domain walls except one domain wall or domain wall pair in the centre of the sensor spiral. The position of the single domain wall or domain wall pair is then monitored. Similarly, a pattern of domain walls may be generated and the position of that pattern monitored. In case of having domain wall generators at both ends of the spiral, a domain wall gap or a domain wall pattern may be generated using the methods described herein. The position of the domain wall gap or domain wall pattern is then monitored.

It is also possible to combine the proposed domain wall stropping structure with a domain wall annihilation coil, such that the sensor may be initialized using different methods depending on the configuration of the mechanical system.

Whilst the examples described herein show an MT sensor with a single spiral configuration, it will be appreciated that the sensor may comprise multiple sensor spiral configurations connected in series. In such cases, a domain wall stopper may be provided along a connecting sensing element that extends between two spirals.

Various modifications, whether by way of addition, deletion and/or substitution, may be made to all of the above described embodiments to provide further embodiments, any and/or all of which are intended to be encompassed by the appended claims.

### Applications

Any of the principles and advantages discussed herein can be applied to other systems, not just to the systems described above. Some embodiments can include a subset of features and/or advantages set forth herein. The elements and operations of the various embodiments described above can be combined to provide further embodiments. The acts of the methods discussed herein can be performed in any order as appropriate. Moreover, the acts of the methods discussed herein can be performed serially or in parallel, as appropriate. While circuits are illustrated in particular arrangements, other equivalent arrangements are possible.

Any of the principles and advantages discussed herein can be implemented in connection with any other systems, apparatus, or methods that benefit could from any of the teachings herein. For instance, any of the principles and advantages discussed herein can be implemented in connection with any devices which can employ correcting rotational angle position data derived from rotating magnetic fields. Additionally, the devices can include any magnetoresistance or Hall effect devices capable of sensing magnetic fields.

Aspects of this disclosure can be implemented in various electronic devices or systems. For instance, phase correction methods and sensors implemented in accordance with any of the principles and advantages discussed herein can be included in various electronic devices and/or in various applications. Examples of the electronic devices and applications can include, but are not limited to, servos, robotics, aircraft, submarines, toothbrushes, biomedical sensing devices, and parts of the consumer electronic products such as semiconductor die and/or packaged modules, electronic test equipment, etc. Further, the electronic devices can include unfinished products, including those for industrial, automotive, and/or medical applications.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or "connected", as generally used herein, refer to two or more elements that may be either directly connected, or connected by way of one or more intermediate elements. Thus, although the various schematics shown in the figures depict example arrangements of elements and components, additional intervening elements, devices, features, or components may be present in an actual embodiment (assuming that the functionality of the depicted circuits is not adversely affected). The words "based on" as used herein are generally intended to encompass being "based solely on" and being "based at least partly on." Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values or distances provided herein are intended to include similar values within a measurement error.

While certain embodiments have been described, these embodiments have been presented by way of example only, and are not intended to limit the scope of the disclosure. Indeed, the novel apparatus, systems, and methods described herein may be embodied in a variety of other forms. Furthermore, various omissions, substitutions and changes in the form of the methods and systems described herein may be made without departing from the spirit of the disclosure.

## Claims

1. A method of initializing a magnetic multi-turn sensor, the multi-turn sensor comprising a length of magnetic track having a plurality of magnetoresistive sensing regions and arranged in at least one spiral configuration having a plurality of corner regions, the method comprising:
generating a first magnetic field in proximity to the multi-turn sensor such that domain walls are generated at a plurality of locations along the length of magnetic track;
applying a current to at least one domain wall stopping structure arranged along at least one portion of the magnetic track, such that a further magnetic field is generated in the region of the at least one domain wall stopping structure; and
applying a rotating magnet field in proximity to the multi-turn sensor, such that the domain walls are caused to propagate around the length of magnetic track, wherein one or more domain walls are annihilated in the region of the at least one domain wall stopping structure.

2. The method of claim 1, wherein the field strength of the further magnetic field generated by the at least one domain wall stopping structure is such that domain walls are prevented from propagating past the at least one domain wall stopping structure.

3. The method of claim 1 or 2, further comprising stopping the current applied to the at least one domain wall stopping structure when one of the following applies:
(i) a single domain wall or a single domain wall pair is present in the multi-turn sensor, or
(ii) a plurality of domain walls having a defined configuration is present in the multi-turn sensor.

4. The method of any preceding claim, wherein the at least one domain wall stopping structure comprises a plurality of domain wall stopping structures,
wherein, optionally, the at least one domain wall stopping structure comprises a first domain wall stopping structure arranged on a first side of the at least one spiral, and a second domain wall stopping structure arranged on a second side of the at least one spiral.

5. The method of any preceding claim, wherein the at least one domain wall stopping structure is arranged along one of the magnetoresistive sensing regions.

6. The method of any preceding claim, wherein the at least one domain wall stopping structure comprises an electrical conductor,
wherein the electrical conductor optionally comprises one or more narrowed portions arranged above or below a respective portion of magnetic track.

7. The method of any preceding claim, wherein generating the first magnetic field comprises one of:
applying a current to at least one electrical conductor arranged in or on a substrate on which the multi-turn sensor is disposed;
applying a current to a conductor extending between at least two opposing corner regions of the at least one spiral; or
moving a magnet in an axial direction towards the multi-turn sensor.

8. A magnetic sensor system, comprising:
a magnetic sensing device at least comprising a magnetic multi-turn sensor, wherein the magnetic multi-turn sensor comprises a length of magnetic track having a plurality of magnetoresistive sensing regions and arranged in at least one spiral configuration having a plurality of corner regions;
a magnet mounted on a rotatable shaft, the magnet being positioned a first distance from the magnetic sensing device such that the magnetic multi-turn sensor is operable to measure a number of turns of a first magnetic field generated by the magnet;
an initialization mechanism operable to generate domain walls at a plurality of locations along the length of magnetic track; and
at least one domain wall stopping structure arranged along at least one portion of the magnetic track, wherein the domain wall stopping structure is configured to generate a further magnetic field when a current pulse is applied thereto, the field strength of the further magnetic field being such that domain walls are prevented from propagating past the at least one domain wall stopping structure.

9. The magnetic sensor system of claim 8, wherein the at least one domain wall stopping structure is arranged along one of the magnetoresistive sensing regions.

10. The magnetic sensor system of claim 8 or 9, wherein the at least one domain wall stopping structure comprises a plurality of domain wall stopping structures,
wherein, optionally, each domain wall stopping structure of the plurality of domain wall stopping structures is arranged on one of the plurality of magnetoresistive sensing elements.

11. The magnetic sensor system of any of claims 8 to 10, wherein the at least one domain wall stopping structure comprises a first domain wall stopping structure arranged on a first side of the at least one spiral, and a second domain wall stopping structure arranged on a second side of the at least one spiral.

12. The magnetic sensor system of any of claims 8 to 11, wherein the at least one domain wall stopping structure comprises an electrical conductor,
wherein the electrical conductor optionally comprises one or more narrowed portions arranged above or below a respective portion of the magnetic track.

13. The magnetic sensor system of any of claims 8 to 12, wherein the length magnetic track comprises a magnetoresistive material, the multi-turn sensor comprising a plurality of contacts for electrically connecting the magnetoresistive material, such that a plurality of magnetoresistive sensing elements connected in series are defined by said contacts to thereby provide the plurality of magnetoresistive sensing regions.

14. The magnetic sensor system of any of claims 8 to 12, wherein the length of magnetic track comprises a ferromagnetic material, the multi-turn sensor comprising a plurality of magnetic tunnel junctions for electrically connecting the magnetic track, such that each of the plurality of magnetoresistive sensing regions is defined by at least one magnetic tunnel junction.

15. A magnetic sensor arrangement, comprising:
a magnetic sensing device at least comprising a magnetic multi-turn sensor, wherein the magnetic multi-turn sensor comprises a length of magnetic track having a plurality of magnetoresistive sensing regions and arranged in at least one spiral configuration having a plurality of corner regions; and
at least one domain wall stopping structure arranged along at least one portion of the magnetic track, wherein the domain wall stopping structure is configured to generate a magnetic field when a current pulse is applied thereto, the field strength of the magnetic field being such that domain walls are prevented from propagating past the at least one domain wall stopping structure.
